# EUROPEAN PATENT APPLICATION

(11) **EP 0 828 347 A2**
(43) Date of publication of application: **11.03.1998**
(21) Application number: 97306763.0
(22) Date of filing: 02.09.1997
(51) Int. Cl.: H03K 3/01, H03K 3/03, H03K 3/354

(54) **Oscillator start-up circuit**

(30) Priority: 09.09.1996 US 711030
(71) Applicant: Hewlett-Packard Company, Palo Alto, California 94304 (US)
(72) Inventor: Mar, Eugene J., Corvallis, OR 97330 (US)
(74) Representative: Colgan, Stephen James

(57) **Abstract**

A start-up circuit is coupled to an oscillator (101) to enable the oscillator to reliably start and continue oscillation. The magnitude of the oscillator signal is compared to a threshold value and when the threshold is exceeded, the oscillator signal is coupled to a load.

## Description

### Background of the Invention

The present invention generally relate to start-up circuitry for electronic oscillators and more particularly relates to an electronic circuit used in association with an integrated circuit oscillator to enable the oscillator to reliably start and continue oscillation.

Oscillator circuits are often plagued with an inability to commence and sustain oscillation when the circuits are employed in practical devices. In an Application Specific Integrated Circuit (ASIC), for example, the oscillator circuit is constructed in the same semiconductor substrate and interconnects with the external world via the same IC input/output connections as the microprocessor, its peripheral circuitry, drivers, and other circuitry. When power is applied to the ASIC, many of the circuits of the IC are in an active or quasi-active state which draws current from the just connected power supply. This current drain creates a voltage drop in the power supply interconnect leads which reduces the available supply voltage to the oscillator circuit.

To make matters worse, the buffer and clock distribution amplifiers may be in an active or partially active state thereby offering a relatively substantial load on the output of the oscillator circuit. The combination of the two foregoing occurrences cause an instability in the start-up of the oscillator and often result in the oscillator being unable to sustain oscillation.

In order to overcome the unreliable start-up problem, others have provided separate power connections to the oscillator, or have made the impedance of the oscillator different from subsequent gain stages, or have introduced additional reactive components within the oscillator feedback loop. While each of these improvements may have resolved the problems faced at that time, the needs of an oscillator in a densely packed ASIC with many inputs/outputs and a large clock signal buffer string have not been adequately addressed.

### Summary of the Invention

An oscillator start-up circuit is coupled to an oscillator and includes an oscillator signal magnitude sensor. The oscillator signal magnitude sensor generates a detect signal when the oscillator signal magnitude exceeds a threshold value. The start-up circuit also includes a switch which is coupled to the oscillator and is responsive to the detect signal to couple the oscillator signal to a signal sink when the oscillator signal magnitude exceeds the threshold value.

### Brief Description of the Drawings

FIG. 1 is a simplified schematic diagram of a preferred embodiment of the present invention.

FIG. 2 is a schematic diagram of an oscillatory circuit, a buffer, and a NAND circuit which may be employed in the present invention.

FIG. 3 is a schematic diagram of an oscillator signal magnitude sensor, amplifier, and latch which may be employed in the present invention.

FIG. 4 is a schematic diagram of a power-on detector which may be employed in the present invention.

FIG. 5 is voltage versus time timing diagram which illustrates the performance of the preferred embodiment of the present invention.

### Detailed Description of a Preferred Embodiment

ASIC circuits generally utilize an integrated clock oscillator and clock distribution circuitry. The clock distribution circuitry typically consists of many buffer amplifiers distributed throughout the geography of an integrated circuit. Upon power start-up, these buffer amplifiers may sit at a bias level in the high gain linear region of their operation and therefore load the output of the oscillator as well as draw current from the power supply. This change in loading can cause the oscillator amplifier to shift its normal dc characteristics and quench any oscillation which may attempt to start. While it is possible to disable the clock buffer circuitry for a long fixed reset time, such a reset time generator is usually realized using components external to the integrated circuit so that a long reset time may be achieved. Furthermore, most oscillators are high Q, particularly crystal controlled oscillators, so a start-up time in the order of several milliseconds must be accommodated. Since it is hard to characterize the length of time required for start-up because variables other than Q, for example, process, voltage and, temperature, can effect the length of time that the oscillator requires for start-up, sufficient margin must be designed into the fixed-time reset. In order to overcome these difficulties, a start-up circuit which unloads the clock buffers from the oscillator until a predetermined magnitude of oscillation amplitude is realized.

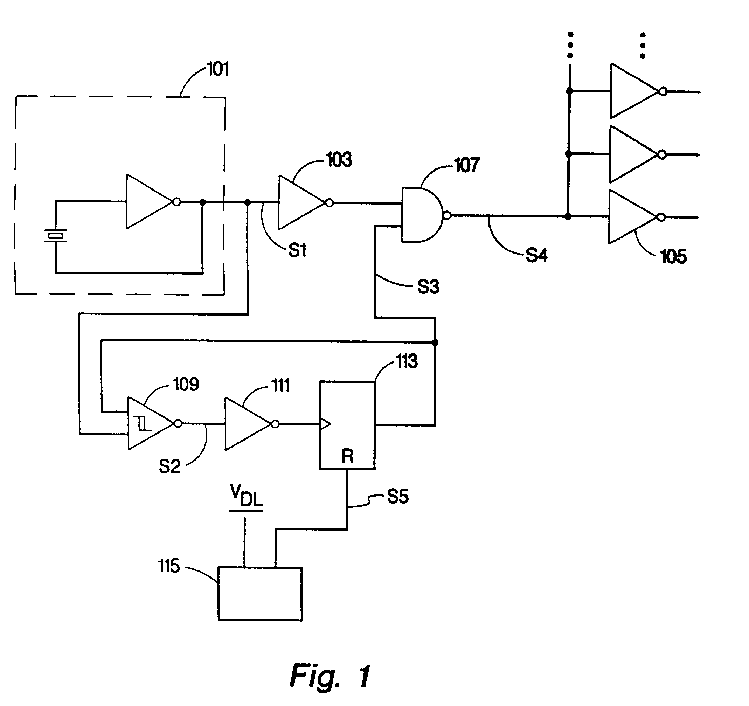

Referring now to FIG. 1, it can be seen that an oscillatory circuit 101 is coupled through a buffer amplifier 103 to a plurality of clock distribution buffer amplifiers such as buffer amplifiers 105 distributed throughout the geography of the integrated circuit. An NAND gate 107 is disposed between buffer amplifier 103 and clock buffer amplifier 105 in order that the oscillator output signal 51 from oscillatory circuit 101 through buffer 103 be blocked until another signal is applied to NAND gate 107.

The oscillator signal 51 output from oscillatory circuit 101 is also coupled to a Schmitt trigger 109 for detection of the magnitude of the oscillator signal. The trigger output signal 52 output from Schmitt trigger 109 is coupled to a buffer amplifier 111 to a latch circuit 113. The latched trigger signal 53 from the latch circuit 113 is coupled to the second input of NAND gate 107 to provide the enabling signal which allows a processed oscillator clock signal 54 to pass to the distributed buffer amplifiers for distribution to the rest of the IC. The output signal 53 of latch circuit 113 is also coupled to the Schmitt trigger 109 in order to disable the operation of the Schmitt trigger, thereby preventing noise pulses from being coupled to the NAND gate 107. Coupled to the reset port of latch 113, is a power-on detect signal 55 supplied by a power-on detector 115. Since the power-on detector 115 provides a power-on signal prior to the build-up of oscillator signal and detection by Schmitt trigger 109, latch circuit 113 is placed in a state which assures the NAND gate 107 will not couple oscillator signals to the distributed buffer amplifier 105 before the oscillatory circuit 101 is ready.

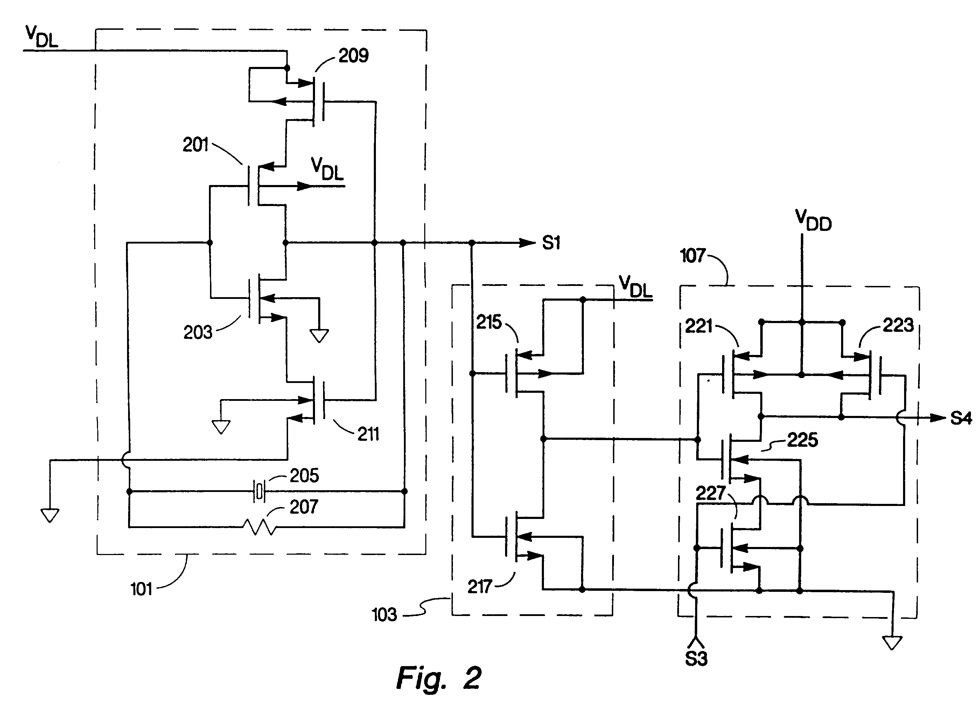

Referring now to FIG. 2, the oscillatory circuit of a preferred embodiment is shown in a detailed schematic. Referring now to FIG. 2, the oscillatory circuit 101, buffer 103, and NAND circuit 107 employed in the preferred embodiment are shown in greater detail. Two field effect transistors, a P-channel transistor 201 and an N-channel transistor 203, form the main gain delivering elements of the circuit and frequency-selective feedback is provided by a series-resonant crystal 205 with bias established by a resistor 207. In the preferred embodiment, the resonant frequency of the circuit is 20 MHz and the value of the resistor 207 is 850Kohms. In order to provide a soft-clipped (more sinusoidal) output, a P-channel field effect transistor 209 is included in series with the source of transistor 201 and an N-channel field effect transistor 211 is included in series with transistor 203. In operation, as transistor 201 turns on, transistor 209 turns off thereby limiting the maximum voltage of the output waveform to a value less than the supply voltage V_{DL} and slowing the rise time of the waveform maximum such that a more sinusoidal waveform (less square-wave) is realized. Similarly, transistor 211 turns off when transistor 203 turns on and limits the minimum waveform voltage and falltime. In the preferred embodiment, the signal S1 output from the oscillatory circuit 101 is set to have a steady-state voltage swing of approximately 1.0V P-P. Further, it is expected that the oscillatory circuit 101 be realized on an integrated circuit. The crystal 205, however, is placed external to the integrated circuit and connected to the oscillatory circuit in a conventional Pierce oscillator configuration.

Two field effect transistors, P-channel transistor 215 and N-channel transistor 217, form the buffer amplifier 103. These transistors are conventionally dimensioned and arranged such that a 50% duty cycle is created for coupling to NAND gate 107.

NAND gate 107 is conventionally realized from two P-channel field effect transistors 221 and 223 and two N-channel field effect transistors 225 and 227. One input to the NAND gate 107 is the signal output from buffer amplifier 103. The other input is the latched trigger signal S3 from the latch 113. In addition to the function of providing the logic negative AND function, the NAND gate 107 provides further power amplification and buffering such that the oscillator clock signal S4 may be applied to the distributed buffer amplifiers 105. NAND gate 107 is coupled to power source V_{DD} while oscillatory circuit 101 and buffer amplifier 103 are coupled to power source V_{DL}. The voltage magnitude of both power sources is approximately 3.3V in the preferred embodiment and are supplied from the same integrated circuit input port but are double-bonded to the input port to provide electrostatic discharge protection and load isolation between the supplies.

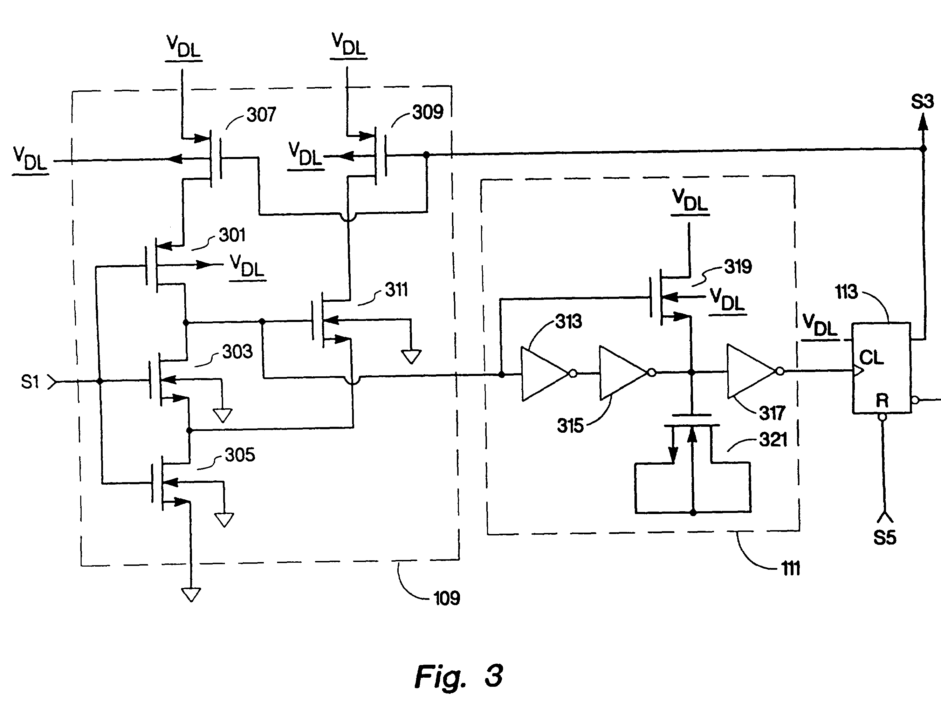

Schmitt trigger 109, buffer amplifier 111, and flip-flop 113 are shown in greater detail in the schematic of FIG. 3. Input of the oscillator output signal 51 is to three field effect transistors, P-channel transistor 301 and N-channel transistors 303 and 305. On power-up the voltage supply is ramping up along with the oscillator output. The Schmitt trigger is used to detect a low to high transition of a predetermined magnitude at the output of the oscillator. The trip point of the Schmitt trigger is set by the ratio of dimensions of the transistor 305 and P-channel field effect transistor 311 to be 250mV above the oscillator bias point of 1.50 Volts. In the preferred embodiment, transistor 305 has a gate width of 10µm and a gate length of 1µm and transistor 311 has a gate width of 5µm and a gate length of 1µm. The use of the 1µm length minimizes the short channel effect. It has been determined that a 250mV peak (500mV P-P) is enough oscillator signal voltage to enable the oscillator clock to be coupled to the remainder of the circuitry of the ASIC without detrimentally effecting the oscillator start-up. Initially, the Schmitt trigger 109 is in an active state and awaits a low to high transition of oscillator signal S1 of sufficient magnitude to provide a trigger output signal S2. When the Schmitt trigger 109 is in the active state, P-channel field effect transistor 307 and P-channel field effect transistor 309 are on. As the voltage magnitude of oscillator signal S1 increases, the source to drain resistance of the transistor 301 increases while the source to drain resistance of the transistors 303 and 305 decreases. The voltage at the gate of the transistor 311 decreases resulting in the source to drain resistance increasing and the source voltage of the transistor 311 decreasing. When a threshold voltage exists between the peak oscillator signal S1 at the gate of the transistor 303 and the voltage at the source of the transistor 303, a high to low transition is output as trigger output signal S2. Trigger output signal S2 is applied to series inverting amplifiers 313 and 315 of buffer amplifier 111. Inverting amplifier 313 is conventionally configured to provide a strong pull-up characteristic to maximize the effect of the high to low transition of Schmitt trigger 109. Similarly, inverting amplifier 315 is conventionally configured to provide a strong pull-down characteristic to maximize the effect of the low to high transition of inverting amplifier 313. To reduce noise transmission, charge storage is provided by the combination of field effect transistors 319 and 321. Transistor 321 is connected in a manner which utilizes the gate capacitance as a charge store which maintains the voltage at the input of the inverting amplifier 317 when transistor 319 and inverting amplifier 315 turn off. Inverting amplifier 317 provides a third signal inversion and is configured to have a strong pull-up characteristic for speed.

In the preferred embodiment, the latch circuit 113 is a D-flip-flop. Output from the buffer amplifier 111 is applied to the clock input of the D-flip-flop 113 and the D output port provides a latched trigger signal 53 coupled to NAND gate 107. The latched trigger signal 53 also disables the Schmitt trigger 109. The latched trigger signal 53 is coupled to the gates of transistors 307 and 309 of the Schmitt trigger 109, providing a logic high to the gates, and turning off the Schmitt trigger circuitry. Thus any noise which might be generated by an active Schmitt trigger is prevented by turning the Schmitt trigger off after the oscillator output signal 51 is of a sufficient magnitude. The arrangement of the latch 113 assures that a positive clock input to the clock port will only set the D-flip-flop. Once the D-flip-flop is set, it cannot be reset unless the power is turned off and turned on again. This turning of the power on, as mentioned above, provides a power-on signal to the reset port of the D-flip-flop latch 113.

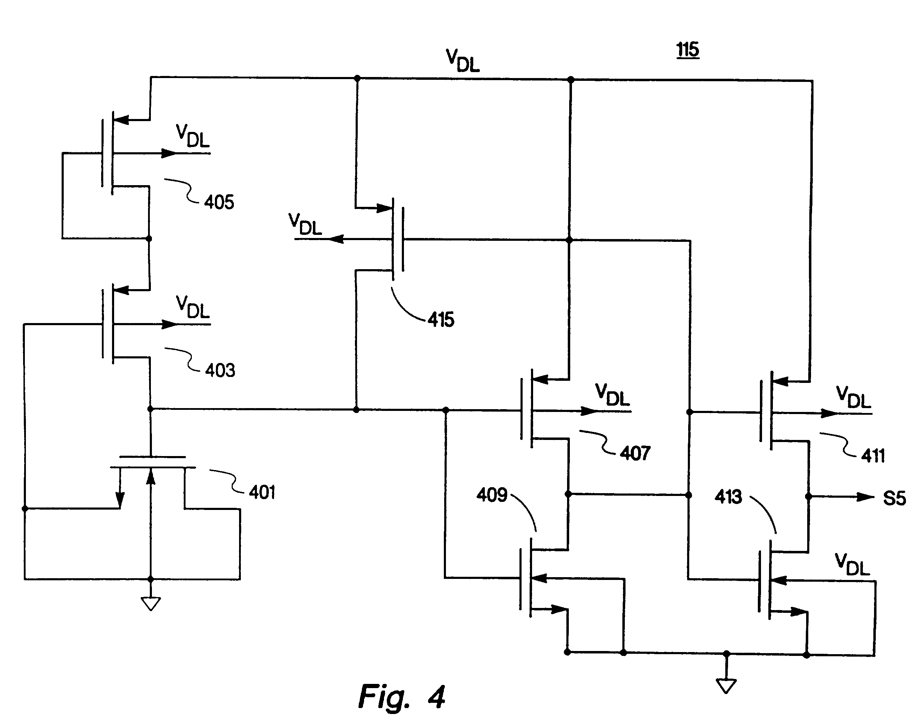

A detailed schematic of the power-on circuit 115 is shown in FIG. 4. The power source, V_{DL}, is applied to the power-on circuit 115 as shown. An N-channel field effect transistor 401 is connected as a capacitor and two P-channel field effect transistors, 403 and 405, are coupled as series resistances to yield a timing circuit having, in the preferred embodiment, a time constant of approximately 240µsec. The output of the timing circuit is coupled to two series coupled inverting amplifiers, the first inverting amplifier including P-channel field effect transistor 407 and N-channel field effect transistor 409 and the second inverting amplifier including P-channel field effect transistor 411 and N-channel field effect transistor 413. A signal at the junction of the two inverting amplifiers is coupled to the gate of a P-channel field effect transistor 415 having its source to drain resistance coupled in parallel with the resistor-forming transistors 403 and 405. As the voltage at the gate of transistor 415 decreases, the resistance of the source to drain resistance decreases, the time constant of the timing circuit is diminished, and the speed of the power-on detect is increased. The power-on detect signal S5, is output from the second of the inverting amplifiers and provides a high logic level to the reset port of latch 113. Thus, at power turn-on the power-on detect signal S5 is at a logic low and causes a reset to be applied to the latch 113. As described above, the reset state of the latch 113 enables the Schmitt detector 109 and disables the NAND gate 107. Any signal output from the oscillatory circuit 101 is not coupled to the clock distributed buffer amplifiers. When the V_{DL} power supply voltage reaches, in the preferred embodiment, approximately 2.3 Volts as shown as curve 501 for the preferred embodiment (after the expiration of the approximately 240µsec. time constant of RC circuit transistors 410, 403, and 405) the power-on detect signal S5 (shown as curve 503 for the preferred embodiment) goes high and allows the latch 113 to proceed in latching a trigger output signal. The power-on detect signal, in the preferred embodiment, occurs in a time less than the time expected for a trigger output signal to be generated.

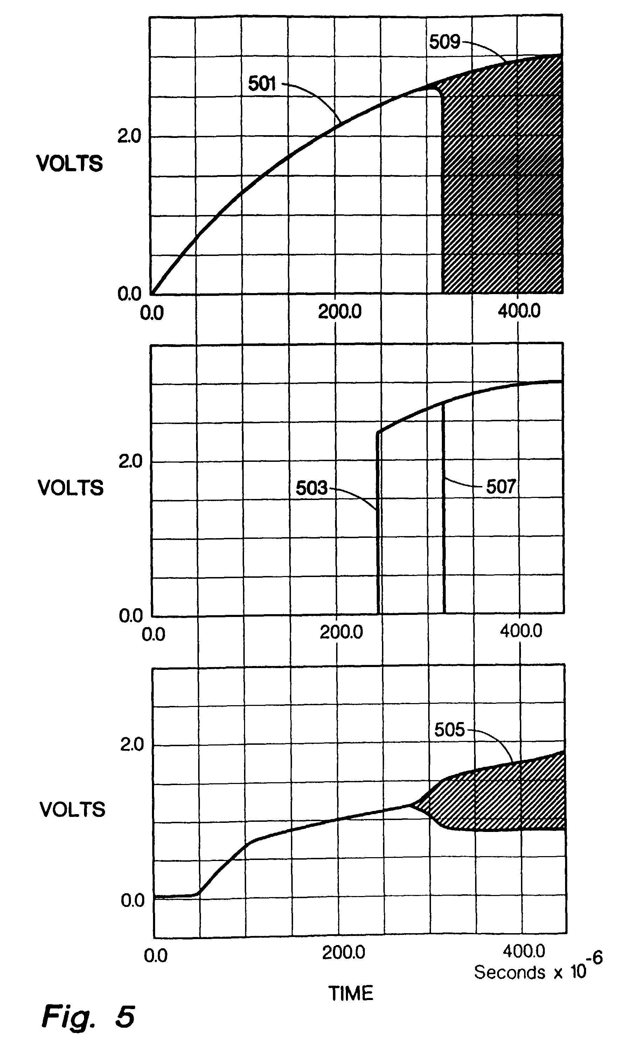

A timing chart, showing signal magnitude in Volts on the vertical axis and time in microseconds on the horizontal axis is plotted in FIG. 5. Curve 501 shows the rise of the power supply voltage V_{DL} from turn-on at time = 0 to time = 450µsec. At approximately time = 240µsec the power-on detect signal S5 transits from a logic low to a logic high state, as shown by the curve 503. This action is followed in time by the oscillator signal S1, shown by curve 505, reaching the peak-to-peak amplitude of approximately 500 mV at time = approximately 310µsec. Within a very short time after the oscillator signal S1 reaches 250 mV, the trigger output signal S2 rises to a logic high state, as shown by curve 507, and the series of events leading to the coupling of the oscillator clock signal S4 are triggered. Curve 509 illustrates the oscillator clock signal S4 being coupled to the clock distributed buffer amplifiers starting at time = approximately 310µsec.

Thus the oscillator circuit output is not coupled to the distributed buffer amplifiers until the oscillator signal has reached the threshold voltage. At that time the NAND gate 107 is activated and the oscillator signal is applied to the remainder of the distributed buffer amplifier clock distribution chain. The circuit of the present invention is fully integrated with the oscillator on the same integrated circuit and overcomes the problems presented by earlier designs.

## Claims

1. An oscillator start-up circuit coupled to an oscillator (101) generating a signal comprising:
an oscillator signal magnitude sensor (109) which generates a detect signal when the oscillator signal magnitude exceeds a threshold value; and
a switch (107, 113), coupled to the oscillator and responsive to said detect signal, whereby the oscillator signal is coupled to an oscillator signal sink when the oscillator signal magnitude exceeds said threshold value.

2. An oscillator start-up circuit in accordance with claim 1 further comprising a power-on detector (115) coupled to said switch and generating a power-on signal when power is applied to the oscillator.

3. An oscillator start-up circuit in accordance with claim 2 wherein said switch further comprises a latch circuit (113) coupled to said power-on detector and responsive to said power-on signal whereby said latch circuit is reset when power is applied to the oscillator.

4. An oscillator start-up circuit in accordance with claim 1 wherein said switch further comprises:
a latch circuit (113) coupled to said oscillator signal magnitude sensor and responsive to said detect signal whereby a latched detect signal is generated when the oscillator signal magnitude exceeds a threshold value; and
a NAND gate (107) coupled to the oscillator at a first input and coupled to said latch circuit at a second input and responsive to said latched detect signal to couple the oscillator signal to an oscillator signal sink when the oscillator signal magnitude exceeds said threshold value.

5. An oscillator start-up circuit in accordance with claim 1 wherein said threshold value further comprises a value greater than 50% of the voltage value of voltage applied to the oscillator as a power source.

6. An integrated circuit clock generation and distribution circuit utilizing a start-up circuit to assure oscillator start-up when power is applied, comprising:
an oscillatory circuit (101) generating an oscillator signal;
at least one buffer amplifier (105) coupling said oscillator signal as a clock to clock dependent circuits of the integrated circuit;
an oscillator signal magnitude sensor (109), coupled to said oscillatory circuit, which generates a detect signal when the oscillator signal magnitude exceeds a threshold value; and
a switch (107, 113), coupled to said oscillatory circuit, said oscillatory circuit, said oscillator signal magnitude sensor, and said at least one buffer amplifier, responsive to said detect signal for coupling said oscillator signal to said at least one buffer amplifier when the oscillator signal magnitude exceeds said threshold value.

7. An integrated circuit clock generation and distribution circuit in accordance with claim 6 further comprising a power-on detector (115) coupled to said switch and generating a power-on signal when power is applied to the oscillator.

8. An integrated circuit clock generation and distribution circuit in accordance with claim 7 wherein said switch further comprises a latch circuit (113) coupled to said power-on detector and responsive to said power-on signal whereby said latch circuit is reset when power is applied to the oscillator.

9. An integrated circuit clock generation and distribution circuit in accordance with claim 6 wherein said switch further comprises:
a latch circuit (113) coupled to said oscillator signal magnitude sensor and responsive to said detect signal whereby a latched detect signal is generated when the oscillator signal magnitude exceeds a threshold value; and
a NAND gate (107) coupled to said oscillatory circuit at a first input, coupled to said latch circuit at a second input, and coupled to said at least one buffer amplifier at an output, and responsive to said latched detect signal to couple said oscillator signal to said at least one buffer amplifier when the oscillator signal magnitude exceeds said threshold value.
